Europäisches Patentamt

(19) European Patent Office

Office européen des brevets

(11) EP 0 834 117 B1

(12) EUROPÄISCHE PATENTSCHRIFT

(45) Veröffentlichungstag und Bekanntmachung des Hinweises auf die Patenterteilung:
28.02.2001 Patentblatt 2001/09

(51) Int Cl.⁷: G06F 7/52

(21) Anmeldenummer: 96915962.3

(22) Anmeldetag: 03.06.1996

(86) Internationale Anmeldenummer:
PCT/DE96/00972

(87) Internationale Veröffentlichungsnummer:
WO 96/42050 (27.12.1996 Gazette 1996/56)

(54) **SCHALTUNGSANORDNUNG ZUM VERGLEICH ZWEIER ELEKTRISCHER GRÖSSEN, DIE VON EINEM ERSTEN NEURON-MOS-FELDEFFEKTTRANSISTOR UND EINER REFERENZQUELLE ZUR VERFÜGUNG GESTELLT WERDEN**

CIRCUIT FOR COMPARING TWO ELECTRICAL QUANTITIES PROVIDED BY A FIRST NEURON MOS FIELD EFFECT TRANSISTOR AND A REFERENCE SOURCE

CIRCUIT PERMETTANT DE COMPARER DEUX GRANDEURS ELECTRIQUES FOURNIES PAR UN PREMIER NEURO-TRANSISTOR A EFFET DE CHAMP MOS ET UNE SOURCE DE REFERENCE

(84) Benannte Vertragsstaaten:
DE FR GB IT

(30) Priorität: 09.06.1995 DE 19521090

(43) Veröffentlichungstag der Anmeldung:
08.04.1998 Patentblatt 1998/15

(73) Patentinhaber: Infineon Technologies AG
81541 München (DE)

(72) Erfinder:
• THEWES, Roland
D-82178 Puchheim (DE)
• PRANGE, Stefan
D-81476 München (DE)
• WOHLRAB, Erdmute
D-81825 München (DE)
• WEBER, Werner
D-80637 München (DE)

(74) Vertreter: Zedlitz, Peter, Dipl.-Inf. et al
Patentanwalt,
Postfach 22 13 17
80503 München (DE)

(56) Entgegenhaltungen:
EP-A- 0 497 319          US-A- 3 950 636

• IEEE TRANSACTIONS ON ELECTRON DEVICES, Bd. 39, Nr. 6, 1.Juni 1992, Seiten 1444-1455, XP000271791 TADASHI SHIBATA ET AL: "A FUNCTIONAL MOS TRANSISTOR FEATURING GATE-LEVEL WEIGHTED SUM AND THRESHOLD OPERATIONS"
• KYOKO TSUKANO ET AL: "A NEW CMOS NEURON CIRCUIT BASED ON A CROSS-COUPLED CURRENT COMPARATOR STRUCTURE" 1.Juli 1992 , IEICE TRANSACTIONS ON FUNDAMENTALS OF ELECTRONICS, COMMUNICATIONS AND COMPUTER SCIENCES, VOL. E75 - A, NR. 7, PAGE(S) 937 - 943 XP000311791 siehe Zusammenfassung siehe Seite 937, Spalte 2, Zeile 21 - Seite 938, Spalte 1, Zeile 3; Abbildung 1 siehe Seite 939, Spalte 2, Zeile 25 - Seite 940, Spalte 1, Zeile 12; Abbildung 4
• TADASHI SHIBATA ET AL: "NEURON MOS BINARY-LOGIC INTEGRATED CIRCUITS - PART II: SIMPLIFYING TECHNIQUES OF CIRCUIT CONFIGURATION AND THEIR PRACTICAL APPLICATIONS" 1.Mai 1993 , IEEE TRANSACTIONS ON ELECTRON DEVICES, VOL. 40, NR. 5, PAGE(S) 974 - 979 XP000364271 siehe Zusammenfassung siehe Seite 975, Spalte 2, Zeile 19 - Zeile 43; Abbildung 3
• ALTA FREQUENZA, Bd. XXXVIII, Nr. 11, November 1969, MILANO IT, Seiten 843-852, XP002014108 FERRARI ET AL: "Some new schemes for parallel multipliers"

**Beschreibung**

Die Aufgabe, zwei elektrische Größen miteinander zu vergleichen, tritt in vielen Gebieten der Technik auf. So sind diese Vergleiche z.B. eine Grundlage der elektrischen Meßtechnik. Auch Schwellenwertgleichungen können mit Hilfe von Bewerterschaltungen technisch realisiert werden.

Verfahren, die elektrische Größen mit Hilfe von Operationsverstärkern vergleichen, sind bekannt und werden häufig verwendet (U.Tietze, Ch.Schenk, Halbleiterschaltungstechnik, 9. Auflage, Springer-Verlag, 1990, Seite 132 bis 143). Ein bedeutender Nachteil dieser Verfahren besteht in der Umsetzung statischer Verlustleistung. Eine weitere Möglichkeit, eine Bewertung zweier elektrischer Größen durchzuführen, besteht in der Verwendung eines Neuron-MOS-Inverters, wobei die Referenzgröße, mit der eine andere elektrische Größe verglichen werden soll, durch die Umschaltschwelle des Neuron-MOS-Inverters bestimmt wird (T.Shibata, P.Ohmi, "A functional MOS-Transistor featuring gate-level weighted sum and threshold operations", IEEE Trans. Electron Devices, 39, 1992, Seite 1444 bis 1455). Die Verwendung eines Neuron-MOS-Inverters in diesem Zusammenhang zeigt einige Nachteile. Es fließt ein statischer Querstrom für alle Potentiale $\Phi_F$ auf dem Floating-Gate der Neuron-MOS-Feldeffekttransistoren mit $V_{SS} + V_{th,n} < \Phi_F < V_{DD} - V_{th,p}$, was während des Betriebs als Schwellenwertgatter dem Normalfall entspricht. Außerdem ist eine extrem gute Beherrschung der Technologieparameter erforderlich, damit die Schwellendimensionierung dem gewünschten Verhalten entspricht, das heißt, daß die Toleranzen der Schwellenwertspannung eingehalten werden können.

Aus EP 0 497 319 A1 ist eine Schaltungsanordnung zum Vergleich zweier elektrischer Größen bekannt, die einen Stromspiegel, zwei MOS-Feldeffekttransistoren sowie eine Inverterstufe aufweist. Die von den beiden Transistoren gelieferten Ströme werden in dem Stromspiegel miteinander verglichen und das Ergebnissignal an den Ausgang der Inverterstufe bereitgestellt. Mit dieser Schaltungsanordnung ist lediglich ein Vergleich zweier elektrischer Größen möglich.

Aus (T. Shibata, A Functional MOS Transistor Featuring Gate-Level Weighted Sum and Threshold Operations, IEEE Transactions on Electron Devices, Vol. 39, No. 6, New York, S. 1144-1455, Juni 1992) sind Grundlagen über den Neuron-MOS-Feldeffekttransistor bekannt.

In US 3 850 635 ist eine zwei Vergleicher enthaltende Multipliziererzelle beschrieben.

Der Erfindung liegt das Problem zugrunde, eine elektrische Größe, die von einem Neuron-MOS-Feldeffekttransistor zur Verfügung gestellt wird, mit einer Referenzgröße zu vergleichen.

Dieses Problem wird durch die Schaltungsanordnung gemäß Patentanspruch 1 gelöst.

Die erfindungsgemäße Schaltungsanordnung besitzt einige positive Eigenschaften. So liegt zu keinem Zeitpunkt am Ausgang der erfindungsgemäßen Schaltungsanordnung ein undefinierter Pegel an, da unmittelbar vom alten in den neuen Zustand geschaltet wird. Diese Eigenschaft ist vorteilhaft bei der weiteren Datenverarbeitung in nachfolgenden Stufen.

Außerdem findet die Bewertung über Ströme und nicht wie häufig bei anderen Bewerterschaltungen üblich, über Ladungen statt. Diese Ströme ergeben sich aus den Potentialen an den (Floating-)Gates der Transistoren, welche niederohmig in einer Gesamtschaltung bereitgestellt werden können. Damit ist die erfindungsgemäße Schaltungsanordnung robust gegen die Einkopplung von Störsignalen und erlaubt eine sicherere Bewertung als das Prinzip der Ladungsbewertung. Es können dadurch z.B. enge Toleranzen für die Schwellenwertbildung bei der Realisierung von Schwellenwertgleichungen eingehalten werden, da im Differenzbetrieb gearbeitet wird. So können sogar so geringe Potentialunterschiede am Floating-Gate von 200 mV sicher getrennt und richtig bewertet werden können.

Ein weiterer Vorteil der erfindungsgemäßen Schaltungsanordnung besteht darin, daß im Ruhezustand der Schaltungsanordnung kein Querstrom fließt, was gegenüber vielen anderen Bewerterschaltungen einen wichtigen Vorteil darstellt.

Für die Verwendung in Array-Schaltungen bietet die erfindungsgemäße Schaltungsanordnung den Vorteil, daß nur eine Steuerleitung nötig ist, um die erfindungsgemäße Schaltungsanordnung zu aktivieren.

Ein Flächenvergleich mit anderen Bewerterschaltungen zeigt, daß die erfindungsgemäße Schaltungsanordnung Vorteile hat, wenn auf eine Entkopplung von Ausgang und eigentlicher Bewerterschaltung, sowie auf Querstromfreiheit Wert gelegt wird. Dies wird durch die Tatsache verdeutlicht, daß für die erfindungsgemäße Schaltungsanordnung nur sechs Transistoren für die Logik sowie ein Neuron-MOS-Feldeffekttransistor und eine Referenzquelle, die ebenfalls einen weiteren Neuron-MOS-Feldeffekttransistor oder einen MOS-Feldeffekttransistor aufweist, benötigt werden.

Weiterbildungen der Erfindung ergeben sich aus den abhängigen Ansprüchen.

Ein bevorzugtes Ausführungsbeispiel der Erfindung ist in den Zeichnungen dargestellt und wird im folgenden näher beschrieben.

Es zeigen

Figur 1     eine Skizze der erfindungsgemäßen Schaltungsanordnung;
Figur 2     eine Skizze, in der die Verwendung der erfindungsgemäßen Schaltungsanordnung in einer Multipliziererzelle dargestellt ist;

Figur 3    eine Skizze, in der die Verwendung der erfindungsgemäßen Schaltungsanordnung innerhalb einer Multi-plizierzelle dargestellt ist, bei der das Übertragsbit direkt im Referenz-Neuron-MOS-Feldeffekttransistor verwendet wird.

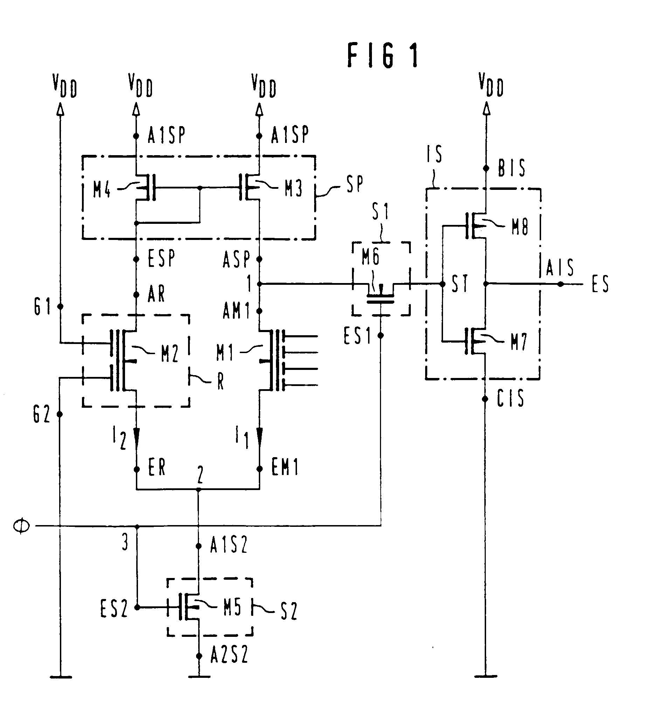

Anhand der Figuren 1 bis 3 wird die erfindungsgemäße Schaltungsanordnung weiter erläutert.

In Figur 1 ist eine erfindungsgemäße Schaltungsanordnung dargestellt zum Vergleich zweier elektrischer Größen, die von einem ersten Neuron-MOS-Feldeffekttransistor M1 und einer Referenzquelle R zur Verfügung gestellt werden. Die erfindungsgemäße Schaltungsanordnung weist prinzipiell folgende Komponenten auf:

- Einen Stromspiegel SP,
- den ersten Neuron-MOS-Feldeffekttransistor MI,
- einen Referenztransistor R, sowie
- eine Inverterstufe IS.

Zusätzlich können noch eine erste Schaltereinheit S1 sowie eine zweite Schaltereinheit S2 vorgesehen sein. Die erste Schaltereinheit S1 und die zweite Schaltereinheit S2 sind für die Funktion der erfindungsgemäßen Schaltungsanordnung nicht wesentlich.

Die im vorigen aufgeführten Komponenten sind in folgender Weise miteinander verbunden: Der erste Neuron-MOS-Feldeffekttransistor M1 ist mit einem Ausgang AM1 des ersten Neuron-MOS-Feldeffekttransistors M1 über einen ersten Anschluß 1 mit einem Ausgang ASP des Stromspiegels SP gekoppelt. Ein Ausgang AR des Referenztransistors R ist mit einem Eingang ESP des Stromspiegels SP verbunden. Ein Eingang EM1 des ersten Neuron-MOS-Feldeffekttransistors MI und ein Eingang ER des Referenztransistors R sind über einen zweiten Anschluß 2 mit einem ersten Anschluß A1S2 der zweiten Schaltereinheit S2 gekoppelt. Ein zweiter Anschluß A2S2 der zweiten Schaltereinheit S2 ist mit dem Massepotential verbunden. Der erste Anschluß 1 ist mit der ersten Schaltereinheit S1 verbunden. Die erste Schaltereinheit S1 ist außerdem gekoppelt mit einem Steueranschluß ST der Inverterstufe IS.

Der Stromspiegel SP besteht aus zwei Transistoren M3 und M4. Die Inverterstufe IS weist zwei Transistoren M7 und M8 auf. Die erste Schaltereinheit S1 weist einen Transistor M6 auf und die zweite Schaltereinheit S2 weist einen Transistor M5 auf. Ein erster Anschluß A1SP des Stromspiegels SP sowie ein zweiter Anschluß A2SP des Stromspiegels SP sind mit einem Betriebspotential $V_{DD}$ gekoppelt. Ebenso mit dem Betriebspotential $V_{DD}$ ist ein Anschluß BIS der Inverterstufe IS gekoppelt. Ein Anschluß CIS der Inverterstufe IS liegt auf Masse.

Ein Steuer-Eingang ES1 der ersten Schaltereinheit sowie ein Steuer-Eingang ES2 der zweiten Schaltereinheit sind über einen Anschluß 3 mit einem Steuersignal $\Phi$ gekoppelt.

Durch die im vorigen beschriebene erfindungsgemäße Schaltungsanordnung wird ein Floating-Gate-Potential $\Phi_F$ des ersten Neuron-MOS-Feldeffekttransistors erzeugt, das die an die Gateanschlüsse des ersten Neuron-MOS-Feldeffekttransistors M1 angelegten Eingangsgrößen repräsentiert. Während der Bewertung ist das Verhältnis eines ersten Stroms $I_1$, der durch den ersten Neuron-MOS-Feldeffekttransistor M1 fließt, und eines zweiten Stroms $I_2$, der durch den Referenztransistor R eine Funktion der Differenz der Floating-Gate-Potentiale des ersten Neuron-MOS-Feldeffekttransistors M1 und des Referenztransistors R. Unter aktiver Bewertung ist in diesem Zusammenhang zu verstehen, daß die Schaltungsanordnung durch die erste Schaltereinheit S1 sowie die zweite Schaltereinheit S2 aktiviert ist. Dazu muß das Steuersignal $\Phi$ aktiv sein. Wenn das Steuersignal $\Phi$ auf hohen Pegel geschaltet ist, liegt an dem ersten Anschluß 1 das Ergebnis der Bewertung an, wobei noch kein voller CMOS-Hub erreicht wird. Dieser wird erst an einem Ausgang AIS der Inverterstufe IS erreicht.

Nach Abschluß der Bewertung wird das Steuersignal $\Phi$ abgeschaltet, wodurch sowohl die erste Schaltereinheit S1 als auch die zweite Schaltereinheit S2 abschalten. Dies bewirkt eine Abkopplung der Inverterstufe IS und des Massepotentials von der eigentlichen Bewerterschaltung. Durch die Ladungserhaltung an den Gates der Transistoren M7 und M8 der Inverter-stufe IS bleiben am Ausgang AIS der Inverterstufe IS definierte Pegel für eine genügend lange Zeit erhalten, ein Ergebnissignal ES des Vergleichs. Das Ergebnissignal ES kann in nachfolgenden Schaltungen ohne Probleme weiter verarbeitet werden. Durch diese Schaltungsanordnung wird erreicht, daß zu keinem Zeitpunkt am Ausgang AIS der Inverterstufe IS ein undefinierter Pegel anliegt. Es wird unmittelbar vom alten in den neuen Zustand geschaltet. Diese Eigenschaft kann vorteilhaft bei der weiteren Datenverarbeitung in nachfolgenden Stufen genutzt werden.

Simulationen haben gezeigt, daß die Funktion der Schaltung Spannungsunterschiede am Floating-Gate $\Phi_F$ des ersten Neuron-MOS-Feldeffekttransistors $\Phi_F$ ab 200 mV noch sicher bewerten kann. Dies liegt vor allem daran, daß die Bewertung in der erfindungsgemäßen Schaltungsanordnung über Ströme durch die Transistoren M1 und M2 stattfindet, welche wiederum durch an deren Gates niederohmig anliegende Potentiale generiert werden. Damit ist die Bewertung robust gegen hochfrequente Störkopplungen und erlaubt eine sichere Bewertung. Somit können auch enge Toleranzen für die Schwellenwertbildung eingehalten werden.

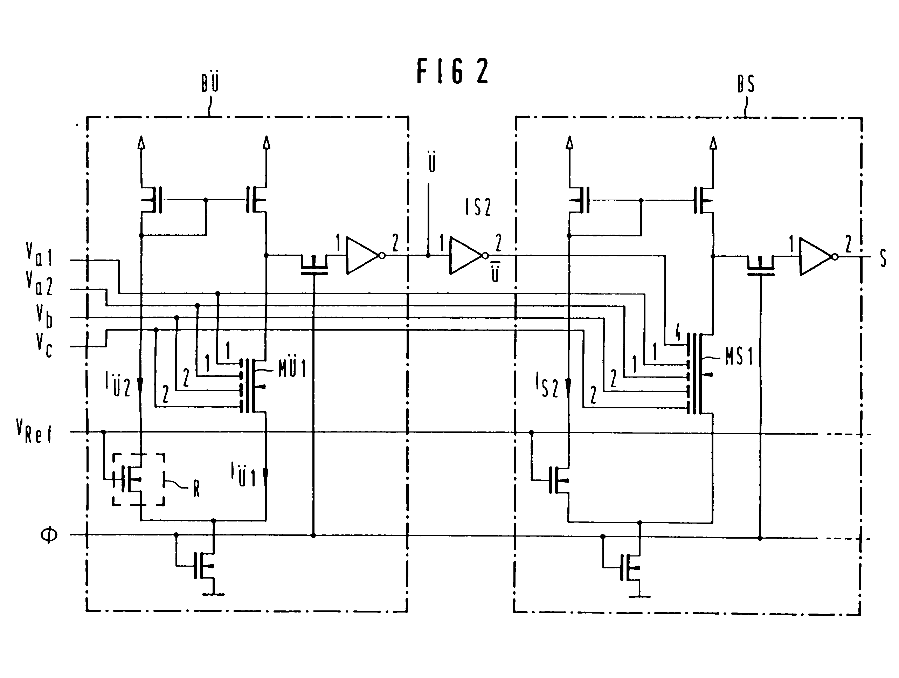

Der Referenztransistor R kann sowohl aus einem zweiten Neuron-MOS-Feldeffekttransistor M2 (vgl. Figur 1) als auch aus einem MOS-Feldeffekttransistor (vgl. Figur 2) gebildet werden. Wenn der Referenztransistor R aus dem zweiten Neuron-MOS-Feldeffekttransistor M2 besteht, so sind mindestens zwei Gateanschlüsse vorgesehen, wobei ein erster Gateanschluß G1 an dem Betriebspotential $V_{DD}$ liegt und ein zweiter Gateanschluß G2 auf Masse liegt. Ein dritter Gateanschluß kann vorgesehen sein zur Feineinstellung Floating-Gate-Potentials des zweiten Neuron-MOS-Feldeffekttransistors M2 und damit der Schaltschwelle der Bewerterschaltung.

Wird ein MOS-Feldeffekttransistor wie in Figur 2 beschrieben verwendet, so erfordert dies eine extern zugeführte oder intern generierte Referenzspannung $V_{Ref}$. Dies kann vorteilhaft sein, wenn eine Feineinstellung des Gate-Potentials des Referenztransistors R und damit der Schaltschwelle der Berwerterschaltung erwünscht ist. Ein weiterer Vorteil liegt darin, daß ein MOS-Feldeffekttransistor weniger Fläche benötigt als ein Neuron-MOS-Feldeffekttransistor und daß eine vorhandene Referenzspannung, die bei Verwendung innerhalb der Schaltung in den ersten Strom $I_1$ umgesetzt wird,für beliebig viele Bewerterschaltungen genutzt werden kann.

In Figur 2 ist eine Verwendung der erfindungsgemäßen Schaltungsanordnung zur Realisierung einer binären Multipliziererzelle beschrieben. Die binäre Multipliziererzelle besteht aus einer ersten Bewerterschaltung BÜ zur Bildung eines Übertrags-Bits ü der binären Multipliziererzelle und einer zweiten Bewerterschaltung BS zur Bildung eines Summen-Bits s der binären Multipliziererzelle. Sowohl die erste Bewertungsschaltung BÜ als auch die zweite Bewertungsschaltung BS entsprechen dem Aufbau der erfindungsgemäßen Schaltungsanordnung (vgl. Figur 1).

Eine binäre Multipliziererzelle bildet das Produkt von zwei Bits und addiert das Partialprodukt von anderen Multipliziererzellen.

Die Gate-Anschlüsse sowohl des ersten Neuron-MOS-Feldeffekttransistors MÜ1 der ersten Bewerterschaltung BÜ als auch die Gateanschlüsse des ersten Neuron-MOS-Feldeffekttransistors MS1 der zweiten Bewerterschaltung BS sind jeweils mit Eingangspotentialen $V_{a1}$, $V_{a2}$, $V_b$ und $V_c$ verbunden. Hierbei repräsentiert das Eingangspotential $V_{a1}$ ein Multiplikator-Bit, das Eingangspotential $V_{a2}$ ein Multiplikanden-Bit, die in der Multipliziererzelle verarbeitet werden. Das Eingangspotential $V_b$ repräsentiert das Summen-Bit eines vorangehenden Partialprodukts. Das Eingangspotential $V_c$ stellt das Übertrags-Bit eines vorangehenden Partialprodukts dar. Die Eingangspotentiale $V_{a1}$, $V_{a2}$, $V_b$ und $V_c$ werden bei dem ersten Neuron-MOS-Feldeffekttransistor MÜ1 der ersten Bewerterschaltung BÜ und bei dem ersten Neuron-MOS-Feldeffekttransistor MS1 der zweiten Bewerterschaltung BS gewichtet in der Weise, daß die Eingangspotentiale $V_{a1}$ und $V_{a2}$ einfach und $V_b$ und $V_c$ relativ dazu zweifach gewichtet werden. Die erste Bewerterschaltung BÜ bildet ein Übertrags-Bit ü. Das Übertrags-Bit ü wird in einer zweiten Inverterstufe IS2 invertiert und an einen weiteren Gateanschluß des ersten Neuron-MOS-Feldeffekttransistors MS1 der zweiten Bewerterschaltung BS gelegt. Die Gewichtung des negierten Übertragsbits beträgt 4,relativ zur Gewichtung z.B. des Eingangspotentials $V_{a1}$.

Der in der ersten Bewerterschaltung BÜ stattfindende Vergleich bei aktivierter Bewerterschaltung BÜ stellt eine technische Realisierung einer Schwellenwertgleichung dar. Der logische Wert des Übertrags-Bits ü der ersten Bewerterschaltung BÜ ist dann und nur dann logisch "1", wenn bei aktiviertem Steuersignal Φ der erste Strom $I_{Ü1}$ der ersten Bewerterschaltung BÜ größer ist als der Referenzstrom $I_{Ü2}$ der ersten Bewerterschaltung BÜ. Mit der im vorigen beschriebenen Gewichtung der Eingangspotentiale an den Gateanschlüssen des ersten Neuron-MOS-Feldeffekttransistors MÜ1 der ersten Bewerterschaltung BÜ stellt die erste Bewerterschaltung BÜ insgesamt folgende Schwellenwertgleichung dar:

$$a_1 + a_2 + 2b + 2c > 3{,}5 \tag{1}$$

Hierbei repräsentieren $a_1$ und $a_2$ das Multiplikator-Bit und das Multiplikanen-Bit, die in der Multipliziererzelle verarbeitet werden. Das Summen-Bit eines vorangehenden Partialprodukts wird durch das Symbol b repräsentiert. Das Übertrags-Bit eines vorangehenden Partialproduktes wird durch das Symbol c gekennzeichnet.

Die zweite Bewerterschaltung BS der Multipliziererzelle bildet aus den im vorigen beschriebenen Eingangspotentialen und dem vierfach gewichteten negierten Übertrags-Bits ü der im vorigen beschriebenen ersten Bewerterschaltung BÜ ein Summen-Bit s der Multipliziererzelle. Hierbei ist das negierte Übertrags-Bit ü mit dem Wert 4 gewichtet und mit einem weiteren Gateanschluß des ersten Neuron-MOS-Feldeffekttransistors MS1 der zweiten Bewerterschaltung BS verbunden. Die Funktion der zweiten Bewerterschaltung BS ist entsprechend der im vorigen beschriebenen erfindungsgemäßen Schaltungsanordnung, wie in Figur 1 dargestellt. Die durch die zweite Bewerterschaltung BS repräsentierte Schwellenwertgleichung lautet somit:

$$a_1 + a_2 + 2b + 2b + 4\bar{u} > 5{,}5 \tag{2}$$

Hierbei repräsentieren die Variablen der oben aufgeführten Formel dieselben Größen wie die Variablen in Formel (1).

In der Schaltungsanordnung nach Figur 2 sind die gleichen Referenzsignale für die erste Bewerterschaltung BÜ und die zweite Bewerterschaltung BS verwendet. Die Lage der jeweiligen Schwelle (3,5 bzw. 5,5) ergibt sich, indem man die Kapazitäten der Eingänge des jeweiligen Neuron-MOS-Feldeffekttransistors zum Floating-Gate und die Kapazität der Floating-Gates zum aktiven Transistor-Gebiet aufsummiert und durch 2 teilt.

In der folgenden Tabelle ist eine Wahrheitstabelle für die binäre Multiplikation angegeben zur Bestätigung der Funktionsweise der im vorigen beschriebenen binären Multipliziererzelle:

| $a_1$ | $a_2$ | b | c | ü | s | $a_1/2+a_2/2+b+c$ | $a_1/2+a_2/2+b+c-2ü$ |
|---|---|---|---|---|---|---|---|
| | | | | | | | |
| 0 | 0 | 0 | 0 | 0 | 0 | 0 | 0 |
| 0 | 0 | 0 | 1 | 0 | 1 | 1 | 1 |
| 0 | 0 | 1 | 0 | 0 | 1 | 1 | 1 |
| 0 | 0 | 1 | 1 | 1 | 0 | 2 | 0 |
| 0 | 1 | 0 | 0 | 0 | 0 | 0,5 | 0,5 |
| 0 | 1 | 0 | 1 | 0 | 1 | 1,5 | 1,5 |
| 0 | 1 | 1 | 0 | 0 | 1 | 1,5 | 1,5 |
| 0 | 1 | 1 | 1 | 1 | 0 | 2,5 | 0,5 |
| 1 | 0 | 0 | 0 | 0 | 0 | 0,5 | 0,5 |
| 1 | 0 | 0 | 1 | 0 | 1 | 1,5 | 1,5 |
| 1 | 0 | 1 | 0 | 0 | 1 | 1,5 | 1,5 |
| 1 | 0 | 1 | 1 | 1 | 0 | 2,5 | 0,5 |
| 1 | 1 | 0 | 0 | 0 | 1 | 1 | 1 |
| 1 | 1 | 0 | 1 | 1 | 0 | 2 | 0 |
| 1 | 1 | 1 | 0 | 1 | 0 | 2 | 0 |
| 1 | 1 | 1 | 1 | 1 | 1 | 3 | 1 |

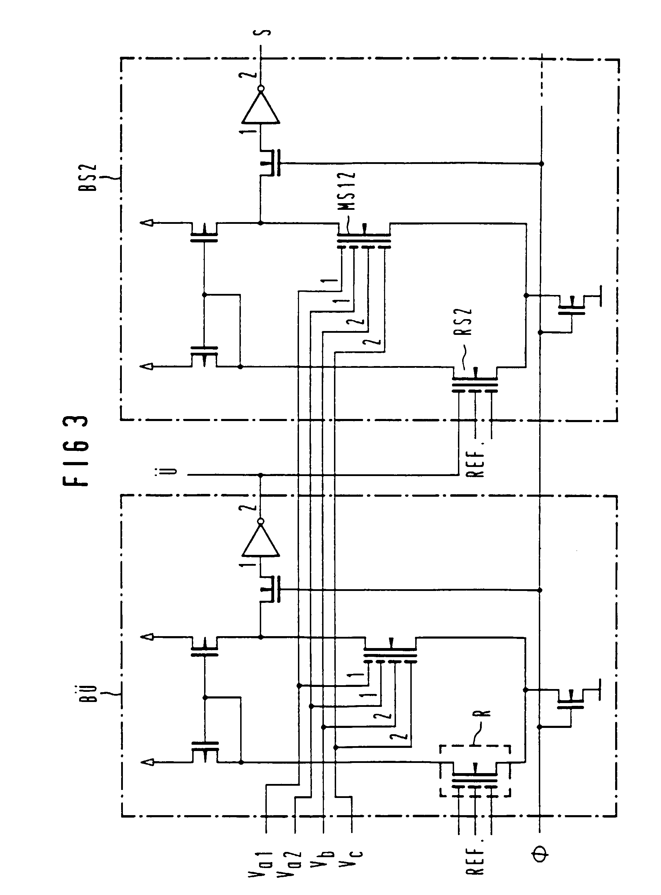

Figur 3 beschreibt eine weitere Möglichkeit, eine binäre Multipliziererzelle unter Verwendung der erfindungsgemäßen Schaltungsanordnung aufzubauen. Hierbei wird der Referenztransistor R durch einen Neuron-MOS-Feldeffekttransistor in der ersten Bewerterschaltung BÜ gebildet. Der Aufbau der ersten Bewerterschaltung BÜ ist im Sonstigen entsprechend der Figur 2 vorgesehen. Im Unterschied zu der in Figur 2 dargestellten zweiten Bewerterschaltung BS ist in der dritten Bewerterschaltung BS2 nicht vorgesehen, das Übertragsbit in negierter Form an einen Gateanschluß eines ersten Neuron-MOS-Feldeffekttransistors MS12 der dritten Bewerterschaltung BS2 zu legen, sondern das Übertragsbit ü wird in nichtnegierter Form direkt an einen weiteren Gateanschluß eines Referenz-Neuron-MOS-Feldeffekttransistors RS2 der dritten Bewerterschaltung BS2 gelegt. Somit stellt die in Figur 3 beschriebene dritte Bewerterschaltung BS2 folgende Ungleichung entsprechend den im vorigen verwendeten Bezeichnungen dar:

$$a_1 + a_2 + 2b + 2c < 1,5 + 4ü \qquad (3)$$

Somit ist das Übertragsbit relativ zu z. B. dem Multiplikandenbit 4fach gewertet. Der gesamte Term (1,5 + 4ü) wird durch eine entsprechende Dimensionierung der Eingangskapazitäten zum Floating-Gate des Referenz-Neuron-MOS-Feldeffekttransistors RS2 der dritten Bewerterschaltung BS2 erreicht. Diese Dimensionierung, sowie alle restlichen vorkommenden Transistoren in der erfindungsgemäßen Schaltungsanordnung sind für den Fachmann leicht berechenbar und durchführbar.

**Patentansprüche**

1.  Schaltungsanordnung zum Vergleich zweier elektrischer Größen, die von einem ersten Neuron-MOS-Feldeffekttransistor (M1) und einem Referenztransistor (R) zur Verfügung gestellt werden,

    -   bei der ein Stromspiegel (SP) vorgesehen ist,
    -   bei der ein Ausgang (AM1) des ersten Neuron-MOS-Feldeffekttransistors (M1) über einen ersten Anschluß (1) mit einem Ausgang (ASP) des Stromspiegels (SP) gekoppelt ist und ein Ausgang (AR) des Referenztransistors (R) mit einem Eingang (ESP) des Stromspiegels (SP) gekoppelt ist,
    -   bei der der erste Anschluß (1) mit mindestens einem Eingang (ST) einer Inverter-Stufe (IS) verbunden ist, an deren Ausgang (AIS) ein Ergebnissignal (ES) des Vergleichs anliegt.

2.  Schaltungsanordnung nach Anspruch 1, bei der eine erste Schaltereinheit (SI) vorgesehen ist, die mit dem ersten Anschluß (1) und mit dem Eingang (ST) der Inverter-Stufe (IS) verbunden ist.

3.  Schaltungsanordnung nach Anspruch 1 oder 2, bei der eine zweite Schaltereinheit (S2) vorgesehen ist, wobei ein erster Anschluß (A1S2) der zweiten Schaltereinheit (S2) über einen zweiten Anschluß (2) mit einem Eingang (EM1) des ersten Neuron-MOS-Feldeffekttransistors (M1) und mit einem Eingang (ER) des Referenztransistors (R) verbunden ist.

4.  Schaltungsanordnung nach einem der Ansprüche 1 bis 3, bei der der Referenztransistor (R) durch einen zweiten Neuron-MOS-Feldeffekttransistor (M2) gebildet wird.

5.  Schaltungsanordnung nach einem der Ansprüche 1 bis 3, bei der die Referenztransistor (R) durch einen MOS-Feldeffekttransistor gebildet wird.

6.  Schaltungsanordnung nach einem der Ansprüche 2 bis 5, bei der die erste Schaltereinheit (S1) und die zweite Schaltereinheit (S2) aus einem MOS-Feldeffekttransistor besteht.

7.  Schaltungsanordnung nach einem der Ansprüche 2 bis 5, bei der die erste Schaltereinheit (S1) oder die zweite Schaltereinheit (S2) aus einem MOS-Feldeffekttransistor besteht.

8.  Schaltungsanordnung nach einem der Ansprüche 1 bis 4 oder 6 oder 7, bei der die erste Schaltereinheit (SI) und die zweite Schaltereinheit (S2) durch ein gemeinsames Steuersignal (Φ) gesteuert werden.

9.  Schaltungsanordnung nach einem der Ansprüche 1 bis 8, bei der eine Puffereinheit zur Pufferung des Ergebnissignals (ES) vorgesehen ist, deren Eingang mit dem Ausgang (AIS) der Inverter-Stufe (IS) verbunden ist.

10. Binäre Multipliziererzelle mit zwei Schaltungsanordnungen nach einem der Ansprüche 1 bis 9 zur Verknüpfung eines Multiplikatorbits ($V_{a1}$), eines Multiplikandenbits ($V_{a2}$), eines Summenbits eines vorangehenden Partialprodukts ($V_b$) und eines Übertrag-Bits eines vorangehenden Partialprodukts ($V_c$) als Eingangspotentiale zu einem Ausgangs-Summen-Bit (s) und einem Ausgangs-Übertrags-Bit (ü),

    -   bei der eine erste Bewerterschaltung (BÜ) vorgesehen ist zur Bildung des Ausgangs-Übertrags-Bits (ü), wobei die erste Bewerterschaltung (BÜ) eine Schaltungsanordnung nach einem der Ansprüche 1 bis 9 ist,
    -   bei der eine zweite Bewerterschaltung (BS) vorgesehen ist zur Bildung des Ausgangs-Summen-Bits (s), wobei die zweite Bewerterschaltung (BS) eine Schaltungsanordnung nach einem der Ansprüche 1 bis 9 ist,
    -   bei der eine zweite Inverterstufe (IS2) vorgesehen ist, wobei an einem Eingang der zweiten Inverterstufe (IS2) das Ausgangs-Übertrags-Bit (ü) anliegt und an einem Ausgang der zweiten Inverterstufe (IS2) ein negiertes Ausgangs-Übertrags-Bit anliegt,
    -   bei der das Multiplikatorbit ($V_{a1}$), das Multiplikandenbit ($V_{a2}$), das Summenbit eines vorangehenden Partialprodukts ($V_b$) und das Übertrags-Bit eines vorangehenden Partialprodukts ($V_c$) gewichtet an Gate-Anschlüsse des ersten Neuron-MOS-Feldeffekttransistors (MÜ1) der ersten Bewerterschaltung (BÜ) und an Gate-Anschlüsse des ersten Neuron-MOS-Feldeffekttransistors (MS1) der zweiten Bewerterschaltung (BS) angelegt sind, und
    -   bei der das negierte Ausgangs-Übertrags-Bit gewichtet an einem weiteren Gate-Anschluß des ersten Neuron-MOS-Feldeffekttransistors (MS1) der zweiten Bewerterschaltung (BS) anliegt.

**Claims**

1. Circuit arrangement for comparing two electrical variables provided by a first neuron MOS field-effect transistor (M1) and a reference transistor (R),

   - in which a current mirror (SP) is provided,
   - in which an output (AM1) of the first neuron MOS field-effect transistor (M1) is coupled to an output (ASP) of the current mirror (SP) by means of a first connection (1), and an output (AR) of the reference transistor (R) is coupled to an input (ESP) of the current mirror (SP),
   - in which the first connection (1) is connected to at least one input (ST) of an inverter stage (IS) whose output (AIS) produces a result signal (ES) for the comparison.

2. Circuit arrangement according to Claim 1, in which a first switch unit (S1) is provided which is connected to the first connection (1) and to the input (ST) of the inverter stage (IS).

3. Circuit arrangement according to Claim 1 or 2, in which a second switch unit (S2) is provided and a first connection (A1S2) of the second switch unit (S2) is connected by means of a second connection (2) to an input (EM1) of the first neuron MOS field-effect transistor (M1) and to an input (ER) of the reference transistor (R).

4. Circuit arrangement according to one of Claims 1 to 3, in which the reference transistor (R) is formed by a second neuron MOS field-effect transistor (M2).

5. Circuit arrangement according to one of Claims 1 to 3, in which the reference transistor (R) is formed by an MOS field-effect transistor.

6. Circuit arrangement according to one of Claims 2 to 5, in which the first switch unit (S1) and the second switch unit (S2) comprise a MOS field-effect transistor.

7. Circuit arrangement according to one of Claims 2 to 5, in which the first switch unit (S1) or the second switch unit (S2) comprises a MOS field-effect transistor.

8. Circuit arrangement according to one of Claims 1 to 4 or 6 or 7, in which the first switch unit (S1) and the second switch unit (S2) are controlled by a common control signal ($\Phi$).

9. Circuit arrangement according to one of Claims 1 to 8, in which a buffer unit is provided for buffering the result signal (ES), the input of said buffer unit being connected to the output (AIS) of the inverter stage (IS).

10. Binary multiplier cell having two circuit arrangements according to one of Claims 1 to 9 for combining a multiplier bit ($V_{a1}$), a multiplicand bit ($V_{a2}$), a sum bit for a preceding partial product (Vb) and a carry bit for a preceding partial product ($V_c$) as input potentials to form an output sum bit (s) and an output carry bit (ü),

    - in which a first weighting circuit (BÜ) is provided for forming the output carry bit (ü), the first weighting circuit (BÜ) being a circuit arrangement according to one of Claims 1 to 9,
    - in which a second weighting circuit (BS) is provided for forming the output sum bit (s), the second weighting circuit (BS) being a circuit arrangement according to one of Claims 1 to 9,
    - in which a second inverter stage (IS2) is provided and the output carry bit (ü) is applied to an input of the second inverter stage (IS2) and a negated output carry bit is produced at an output of the second inverter stage (IS2),
    - in which the multiplier bit ($V_{a1}$), the multiplicand bit ($V_{a2}$), the sum bit for a preceding partial product ($V_b$) and the carry bit for a preceding partial product ($V_c$) are applied in weighted form to gate connections of the first neuron MOS field-effect transistor (MÜ1) in the first weighting circuit (BÜ) and to gate connections of the first neuron MOS field-effect transistor (MS1) in the second weighting circuit (BS), and
    - in which the negated output carry bit is applied in weighted form to a further gate connection of the first neuron MOS field-effect transistor (MS1) in the second weighting circuit (BS).

**EP 0 834 117 B1**

**Revendications**

1. Montage pour comparer deux grandeurs électriques qui sont fournies par un premier neuro-transistor (M1) à effet de champ MOS et un transistor de référence (R) dans lequel

   - est prévu un miroir de courant (SP),
   - est couplée une sortie (AM1) du premier neuro-transistor (M1) à effet de champ MOS, par l'intermédiaire d'une première borne (1), à une sortie (ASP) du miroir de courant (SP) et est couplée une sortie (AR) du transistor de référence (R) à une entrée (ESP) du miroir de courant (SP),
   - est reliée la première borne (1) à au moins une entrée (ST) d'un étage inverseur (IS), à la sortie duquel est délivré un signal (ES) comme résultat de la comparaison.

2. Montage selon la revendication 1 dans lequel est prévue une première unité de commutation (S1), qui est reliée à la première borne (1) et à l'entrée (ST) de l'étage inverseur (IS).

3. Montage selon la revendication 1 ou 2 dans lequel est prévue une deuxième unité de commutation (S2), une première borne (A1S2) de la deuxième unité de commutation (S2) étant reliée, par l'intermédiaire d'une deuxième borne (2), à une entrée (EM1) du premier neuro-transistor (M1) à effet de champ MOS et à une entrée (ER) du transistor de référence (R).

4. Montage selon l'une des revendications 1 à 3 dans lequel le transistor de référence (R) est formé par un deuxième neuro-transistor (M2) à effet de champ MOS.

5. Montage selon l'une des revendications 1 à 3 dans lequel le transistor de référence (R) est formé par un transistor à effet de champ MOS.

6. Montage selon l'une des revendications 2 à 5 dans lequel la première unité de commutation (S1) et la deuxième unité de commutation (S2) sont constituées par un transistor à effet de champ MOS.

7. Montage selon l'une des revendications 2 à 5 dans lequel la première unité de commutation (S1) ou la deuxième unité de commutation (S2) sont constituées par un transistor à effet de champ MOS.

8. Montage selon l'une des revendications 1 à 4 ou 6 ou 7 dans lequel la première unité de commutation (S1) et la deuxième unité de commutation (S2) sont commandées par un signal de commande commun ($\Phi$).

9. Montage selon l'une des revendications 1 à 8 dans lequel est prévue, pour la mémorisation temporaire du signal de résultat (ES), une unité tampon dont l'entrée est reliée à la sortie (AIS) de l'étage inverseur (IS).

10. Cellule binaire de multiplication avec deux montages selon l'une des revendications 1 à 9, pour combiner un bit multiplicateur ($V_{a1}$), un bit multiplicande ($V_{a2}$), un bit d'addition ($V_b$) d'un produit partiel précédent et un bit de report ($V_c$) d'un produit partiel précédent en tant que potentiels d'entrée, en vue de former un bit d'addition (s) de sortie et un bit de report (ü) de sortie,

    - dans laquelle est prévu un premier circuit d'évaluation (BÜ) pour former le bit de report (ü) de sortie, le premier circuit d'évaluation (BÜ) étant un montage selon l'une des revendications 1 à 9,
    - dans laquelle est prévu un deuxième circuit d'évaluation (BS) pour former le bit d'addition (s) de sortie, le deuxième circuit d'évaluation (BS) étant un montage selon l'une des revendications 1 à 9,
    - dans laquelle est prévu un deuxième étage inverseur (IS2), le bit de report (ü) de sortie étant appliqué à une entrée du deuxième étage inverseur (IS2) et le bit de report de sortie, inversé, étant appliqué à une sortie du deuxième étage inverseur (IS2),
    - dans laquelle le bit multiplicateur ($V_{a1}$), le bit multiplicande ($V_{a2}$), le bit d'addition ($V_b$) d'un produit partiel précédent et le bit de report ($V_c$) d'un produit partiel précédent sont appliqués, avec une pondération, à des bornes de grille du premier neuro-transistor (MÜ1) à effet de champ MOS du premier circuit d'évaluation (BÜ) et à des bornes de grille du premier neuro-transistor (MS1) à effet de champ MOS du deuxième circuit d'évaluation (BS) et
    - dans laquelle le bit de report de sortie inversé est appliqué, avec pondération, à une autre borne de grille du premier neuro-transistor (MS1) à effet de champ MOS du deuxième circuit d'évaluation (BS).

# FIG 1

# FIG 2

EP 0 834 117 B1

FIG 3